# EUROPEAN PATENT SPECIFICATION

(11) **EP 0 516 225 B1**
(45) Date of publication and mention of the grant of the patent: **03.09.1997**
(21) Application number: 92201461.8
(22) Date of filing: 22.05.1992
(51) Int. Cl.: G11C 16/06

(54) **Precharging circuit of bit line for reading an EPROM memory cell**
Bitleitungsvorladungsschaltung zum Lesen einer EPROM-Speicherzelle
Circuit de précharge de ligne de bit pour lire une cellule de mémoire EPROM

(30) Priority: 30.05.1991 IT MI911485
(43) Date of publication of application: 02.12.1992
(73) Proprietor: SGS-THOMSON MICROELECTRONICS s.r.l., 20041 Agrate Brianza (Milano) (IT)
(72) Inventor: Villa, Corrado, I-20050 Sovico (Milano) (IT)
(74) Representative: Mittler, Enrico

(56) References cited:
- EP-A- 0 329 141
- EP-A- 0 412 837

## Description

The present invention relates to a precharging circuit of bit line for reading an EPROM memory cell.

One of the problems that have not been completely solved in the accomplishment of a circuit for reading an EPROM memory cell is "soft-writing".

This is an phenomenon due to which an EPROM memory cell put in the reading condition for a sufficiently long period of time tends to be subjected to an undesirable threshold jump if the gate voltage and the drain voltage are sufficiently high.

The limit value of these two voltages at which the "soft-writing" phenomenon begins to be exibited tends to be lowered as new technologies provide cells with ever lower channel lengths and oxide thicknesses.

This is the reason why, if the entire power supply voltage (Vcc) is used for the gate of the cell during reading, it is necessary to keep the drain of the cell itself at a value that is a sufficiently small fraction of the same power supply voltage.

A classic method of solving the problem provides for the drain voltage of an EPROM cell to be regulated by a regulating transistor which is in turn driven by an inverter with two transistors arranged as a half-bridge that uses as input the same drain voltage of the EPROM cell, see for instance EP-A-0 329 141. The W/L ratios between the thickness and the channel length, and thus the gains, of the two transistors of the inverter are very different, so that a drain voltage only slightly higher than the threshold of the transistor with the larger ratio is the highest that can be had. For higher voltages the inverter output tends to quench the regulating transistor completely taking the drain voltage back to a lower value.

An arrangement of this type still leaves the problem of reaching the asymptotic drain voltage (hereinafter indicated with Vd) in a sufficiently short time, so as not to penalize the overall access time; in practice the bit line, having a capacity of a few pF, is to be precharged to the voltage Vd in a time of less than 10 nsec.

According to this arrangement, upstream from the regulating transistor, there is a further diode-connected transistor, which, however, is not capable of supplying the current necessary for a fast precharge, since it is used as the charge for the EPROM memory cell and thus has somewhat resistive size.

The preamble of claim 1 is based on a classic solution adopted for the fast precharge of the bit line provides for the regulating transistor to have the gate and the source in common with a fast precharge transistor, whose drain is connected to the power supply Vcc through a high-gain control transistor. In this way, the abovementioned fast precharge transistor is also subjected to the same regulation imposed by the transistors of the inverter, but it is capable of providing a much higher current at start-up, shortening the time for reaching the asymptotic drain voltage Vd.

This solution also has some disadvantages.

The fast precharge transistor in fact disturbs the reading of the EPROM cell since the current absorbed by it, once the voltage Vd has been reached, is not supplied entirely by the charge transistor, but also by the same fast precharge transistor; for this reason it is indispensable to provide a control signal CK applied across the gate of the control transistor and active only during the precharge step.

In spite of the presence of the high-gain control transistor, the reading of the cell is in any case disturbed during the transitory following its quenching; in fact, assuming the dimensions of the regulating transistor and of the fast precharge transistor to be the same, at the end of the precharge these transistors give the same current; if the control transistor is suddenly quenched, the regulating transistor must provide a supplementary current, with a further small adjustment of the voltage Vd. This variation is potentially slow because it is driven only by the addressed cell, which must discharge the bit line capacity so that the inverter, reacting, increases the gate voltage of the regulating transistor coherently with the larger current required. Thus the drain voltage reached at the end of the precharge is slightly different from the voltage Vd set by the unit formed by the regulating transistor and by the inverter. The sizes of the various transistors of the system become somewhat critical: a fairly low W/L ratio of the fast precharge transistor tends to make its action ineffective, vice versa a high ratio can generate too high a level of the drain voltage before the inverter is capable of reacting.

The object of the present invention is to overcome the abovementioned drawbacks by accomplishing a circuit with a function similar to that described earlier, with no control transistor and wherein the asymptotic value Vd of the drain voltage is reached with no extensions and without the need of small adjustments at the end of the precharge, allowing reading to take place without having to wait a time for eliminating any possible noise introduced by the regulating and fast precharge transistors.

According to the invention such objects are attained with a precharging circuit for a bit line for reading an EPROM memory cell, comprising the features set out in claim 1.

Since the fast precharge transistor is quenched when the asymptotic drain voltage is reached, it is possible to do away with the high-gain control transistor and with the corresponding control signal.

Moreover, the system tends asymptotically to the voltage Vd without any superextensions and with no need for adjustments at the end of the precharge, so that it is possible to carry out the reading without providing for a precharge time in which there are noises introduced by the regulating and fast precharge transistors.

The features of the present invention shall be made more evident by the following detailed description of an embodiment illustrated as a non-limiting example in the enclosed drawings, wherein:
Fig. 1 illustrates an embodiment of the circuit according to the present invention;
Fig. 2 illustrates the curves of some variables present in the circuit.

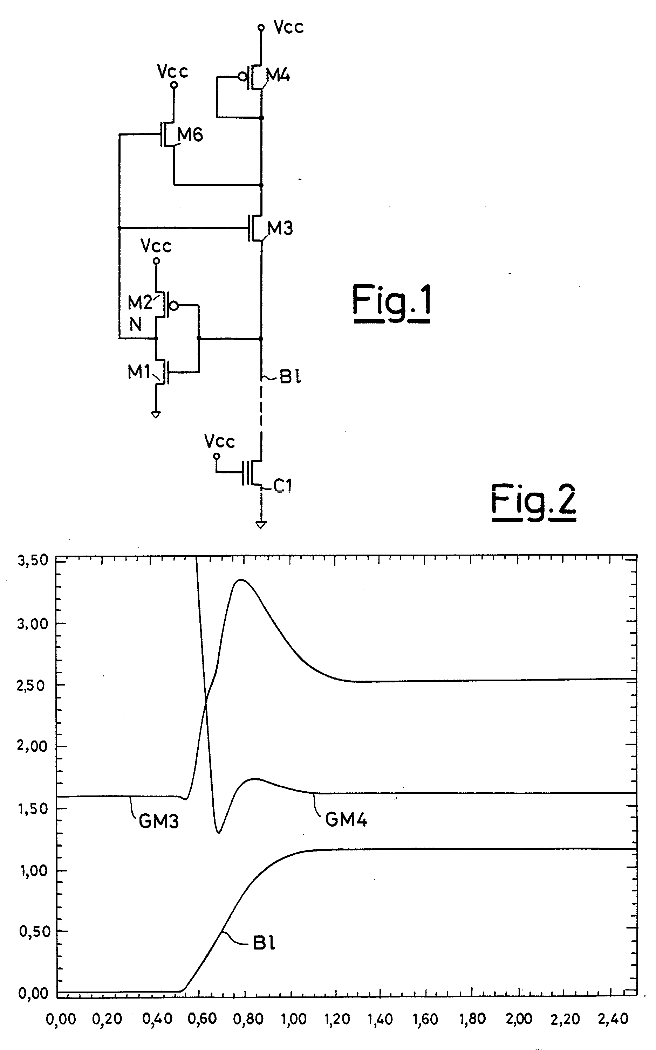

With reference to Fig. 1, the circuit according to the present invention comprises an n-channel MOS transistor M3 which provides the regulation of the drain voltage of an EPROM cell C1 to be read. The control gate of the cell C1 is connected during the reading step to a power supply voltage Vcc, the source of the cell is grounded, the drain is connected to the source of the regulating transistor M3 and like it is arranged along a bit line Bl.

The circuit also comprises an inverter M1, M2 for driving the regulating transistor M3. The inverter comprises a p-channel MOS transistor M2 and an n-channel MOS transistor M1. The source of the transistor M2 is connected to the power supply Vcc and the drain is connected to the drain of the transistor M1 at a circuit node N. The source of the transistor M1 is grounded. The gates of the transistors M1 and M2 are connected together and to the source of the transistor M3 along the bit line. The gate of the regulating transistor M3 is connected to the circuit node N.

To the drain of the transistor M3 there are connected the drain and the gate of a p-channel MOS transistor M4 which provides the charge of the EPROM cell C1. The source of the transistor M4 is connected to the power supply Vcc.

To the drain of the transistor M3 there is also connected the source of an n-channel MOS transistor M6 which provides the fast charge of the bit line Bl. The gate of the transistor M6 is connected to the gate of the regulating transistor M3, while the drain of the transistor M6 is connected to the power supply Vcc.

As shown by the curves of the voltage V_{Bl} across the bit line Bl, of the voltage V_{GM3} across the gate of the transistor M3 and of the voltage V_{GM4} across the gate and across the drain of the transistor M4 (expressed in volts) against time (expressed in seconds), illustrated in Fig. 2, the circuit according to the invention operates as follows.

At the beginning of the reading step, the application of the power supply voltage Vcc determines through the inverter M1, M2 the generation of a gate voltage V_{GM3}, which controls the regulating transistor M3 and the precharge transistor M6 so as to accomplish the fast precharge of the bit line as illustrated by the curve V_{Bl}. At the same time the voltage V_{GM4} across the gate of the charge transistor M4 reaches the asymptotic value Vd.

When the asymptotic value Vd is reached, the voltage V_{GM3} also reaches a value such as to cause the quenching of the transistor M6.

Thus at the end of the precharge step the transistor M6 is quenched and no longer absorbs any current. Moreover, the asymptotic value Vd is reached without any superextensions and with no need for adjustments at the end of the precharge. The reading of the cell may thus take place at any time without waiting for the time necessary for the exhaustion of any possible noise introduced by the transistors M3, M6.

## Claims

1. Precharging circuit for a bit line for reading an EPROM memory cell, comprising a regulating transistor (M3) having its source connected to said bit line, for regulating the drain voltage of the cell (C1), a load (M4) connected between a supply voltage (Vcc) and the drain of said regulating transistor (M3), an inverter (M1, M2) for driving the regulating transistor (M3), having as input the same drain voltage of the cell (1), and a fast precharge transistor (M6), that has the gate connected to the gate of the regulating transistor (M3) and has its drain connected to said supply voltage characterised in that the source of the fast precharge transistor (M6) is connected to the drain of the regulating transistor (M3), so that the drain voltage of the regulating transistor (M3), rising at the end of the precharge of the bit line (Bl), causes the quenching of said fast precharge transistor (M6).

2. Precharging circuit according to claim 1, characterised in that it comprises a charge transistor (M4) of the memory cell (C1), inserted in the bit line (Bl) between said power supply voltage (Vcc) and the regulating transistor (M3) as said load.

## Patentansprüche

1. Vorladeschaltung für eine Bitleitung zum Lesen einer EPROM-Speicherzelle, aufweisend
einen regelnden Transistor (M3), dessen Source mit der Bitleitung verbunden ist, zum Regeln der Drainspannung der Zelle (C1),
eine zwischen eine Versorgungsspannung (Vcc) und Drain des regelnden Transistors (M3) geschaltete Last (M4),
einen Inverter (M1, M2) zum Ansteuern des regelnden Transistors (M3), der als Eingang die gleiche Spannung wie die DrainSpannung der Zelle (1) hat, und
einen schnellen Vorladetransistor (M6), dessen Gate mit dem Gate des regelnden Transistors (M3) verbunden ist und dessen Drain mit der Versorgungsspannung verbunden ist,
**dadurch gekennzeichnet, daß**
Source des schnellen Vorladetransistors (M6) mit Drain des regelnden Transistors (M3) verbunden ist, so daß die Drain-Spannung des regelnden Transistors (M3), am Ende des Vorladens der Bitleitung (B1) ansteigend, das Löschen des schnellen Vorladetransistors (M6) verursacht.

2. Vorladeschaltung nach Anspruch 1, **dadurch gekennzeichnet, daß** sie einen Ladetransistor (M4) der Speicherzelle (C1) aufweist, der in die Bitleitung (B1) zwischen der Versorgungsspannung (Vcc) und dem regelnden Transistor (M3) als die Last eingefügt ist.

## Revendications

1. Circuit de précharge de ligne de bit pour lire une cellule mémoire EPROM comprenant un transistor de régulation (M3) ayant sa source connectée à la ligne de bit pour réguler la tension de drain de la cellule (C1), une charge (M4) connectée entre une tension d'alimentation (Vcc) et le drain du transistor de régulation (M3), un inverseur (M1, M2) pour piloter le transistor de régulation (M3), ayant comme entrée la tension de drain de la cellule (C1), et un transistor de précharge rapide (M6) ayant sa grille connectée à la grille du transistor de régulation (M3) et son drain connecté à la tension d'alimentation, caractérisé en ce que la source du transistor de précharge rapide (M6) est connectée au drain du transistor de régulation (M3) de sorte que la tension de drain du transistor de régulation (M3), qui monte à la fin de la précharge de la ligne (BL), provoque le blocage du transistor de précharge rapide (M6).

2. Circuit de précharge selon la revendication 1, caractérisé en ce qu'il comprend un transistor de charge (M4) de la cellule mémoire (C1), inséré dans la ligne de bit (BL) entre une tension d'alimentation (Vcc) et le transistor de régulation (M3), en tant que charge.
